(19) **Europäisches Patentamt** / **European Patent Office** / **Office européen des brevets**

(11) **EP 1 650 766 B1**

(12) **FASCICULE DE BREVET EUROPEEN**

(45) Date de publication et mention
de la délivrance du brevet:
**14.05.2008 Bulletin 2008/20**

(51) Int Cl.:
***G11C 16/16*** *(2006.01)*    ***G06F 12/02*** *(2006.01)*
***G11C 8/12*** *(2006.01)*

(21) Numéro de dépôt: **05300761.3**

(22) Date de dépôt: **20.09.2005**

(54) **Procédé de gestion pour l'effacement d'une mémoire de type flash, et compteur électrique comprenant une mémoire de type flash**

Verfahren zum Löschen eines Flash-Speichers und Zähler mit einem Flash-Speicher

Method for erasing a flash memory and counter comprising a flash memory

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **20.10.2004 FR 0452379**

(43) Date de publication de la demande:
**26.04.2006 Bulletin 2006/17**

(73) Titulaire: **Actaris SAS**
**92100 Boulogne Billancourt (FR)**

(72) Inventeurs:
• **Cornet, Philippe**
**86360 Chasseneuil du Poitou (FR)**
• **Guillot, Hélène**
**86280 Saint Benoit (FR)**

(74) Mandataire: **Hervouet, Sylvie et al**
**39/41, avenue Aristide Briand**
**92163 Antony Cedex (FR)**

(56) Documents cités:
**EP-A- 0 392 895        EP-A- 0 893 799**
**EP-A- 1 063 652        US-A- 5 991 206**
**US-A1- 2002 181 315    US-A1- 2003 099 134**

## Description

La présente invention concerne la gestion logicielle d'une mémoire de type flash, et plus particulièrement la gestion pour l'effacement d'une mémoire de type flash.

La mémoire flash est une mémoire à semi-conducteurs, réinscriptible et non volatile, c'est-à-dire une mémoire capable de conserver les données même lorsque l'alimentation électrique est coupée.

De nombreux domaines utiisent à l'heure actuelle des mémoires de type flash. Par exemple, dans le domaine non limitatif des compteurs électriques, on utilise les mémoires de type flash pour conserver des programmes ou codes applicatifs permettant le fonctionnement du compteur électrique, ou encore pour conserver les données qui vont servir notamment à la tarification. On comprend aisément que ces programmes, codes applicatifs et données doivent subsister suite à une coupure de courant.

L'un des aspects de la gestion logicielle d'une mémoire de type flash concerne l'effacement partiel ou total de la mémoire, notamment pour pouvoir y inscrire d'autres données. Une mémoire de type flash est composée de plusieurs secteurs physiques, et la technologie des mémoires flash impose un effacement secteur par secteur. Plus précisément, l'effacement d'un secteur physique de mémoire flash s'effectue classiquement par l'écriture d'une commande d'effacement dans le secteur physique à effacer. La mise en oeuvre logicielle consiste en une séquence contenant l'adresse physique du secteur à effacer, ainsi que la commande d'effacement proprement dite. Cela suppose donc que, pour une mémoire donnée, on connaisse au préalable, d'une part, sa composition en terme de secteurs physiques, c'est-à-dire le nombre de secteurs physiques composant la mémoire, et d'autre part, les différentes adresses physiques de ces secteurs, de manière à pouvoir procéder à leur effacement.

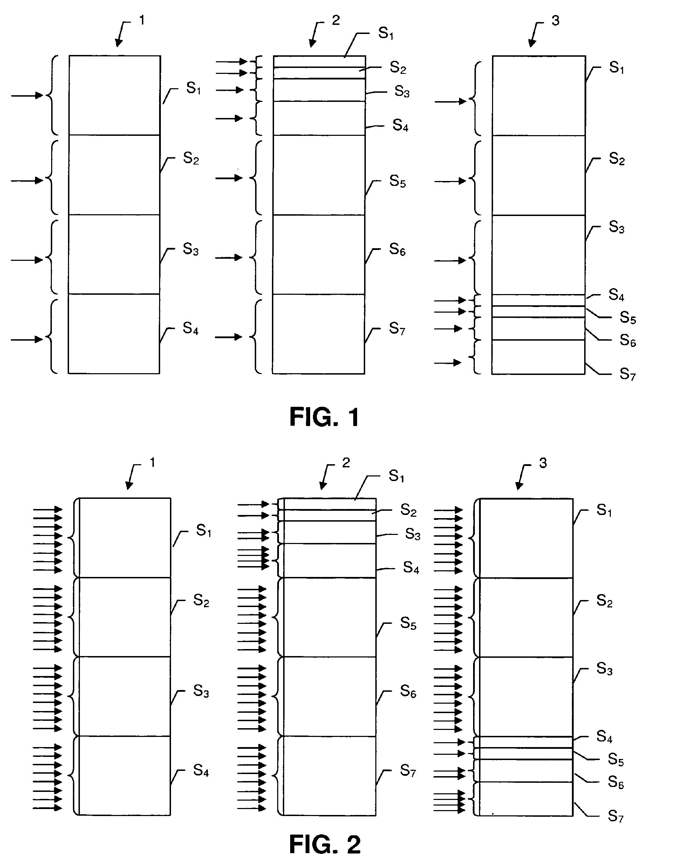

Or, dans la pratique, les secteurs physiques d'une même mémoire flash n'ont pas obligatoirement la même taille. En outre, il existe plusieurs types de mémoires flash, qui, tout en présentant une taille totale identique de mémoire, présente une organisation différente de secteurs physiques. Cette diversité est illustrée schématiquement sur la figure 1 qui montre trois types de mémoires flash 1 à 3 présentant une taille totale de mémoire identique. Dans le premier cas, la mémoire 1 est divisée en quatre secteurs physiques $S_1$ à $S_4$ de taille identique A. Dans le deuxième cas, la mémoire 2 est divisée en sept secteurs physiques dont seuls trois secteurs $S_5$ à $S_7$ présentent une taille identique A, les quatre autres secteurs $S_1$ à $S_4$ présentant des tailles inférieures à A. Le troisième cas est similaire au deuxième cas, à ceci près que la position des secteurs physiques est inversée.

Pour gérer l'effacement de la mémoire 1 selon les techniques connues, il est nécessaire de prévoir quatre commandes d'effacement, une par secteur physique, alors que la gestion des effacements pour les mémoires 2 et 3 nécessite sept commandes d'effacement. Les commandes d'effacement ont été représentées par des flèches continues sur la gauche de chacun des secteurs.

Jusqu'à présent, le problème de la diversité des types de mémoire flash était contourné en imposant d'utiliser toujours le même type de mémoires, pour lequel la gestion de l'effacement est figée une fois pour toute au niveau du microcontrôleur gérant la mémoire flash.

Cependant, il devient de plus en plus difficile de s'approvisionner auprès de plusieurs fabricants de mémoire flash tout en imposant le type de mémoire.

La présente invention a pour but de remédier aux inconvénients précédents en proposant une gestion logicielle transparente de différents types de mémoires flash, de manière à permettre à l'appareil équipé d'une mémoire flash de fonctionner sans qu'il soit nécessaire de connaître au préalable le type de mémoire flash utilisé.

Pour ce faire, la présente invention a pour objet un procédé de gestion pour l'effacement d'une mémoire de type flash caractérisé en ce que, ladite mémoire étant composée d'un nombre non défini de secteurs physiques de tailles variables et étant choisie dans un ensemble de mémoires possibles de taille mémoire totale T identique, il consiste à :

- Partitionner ladite mémoire en une pluralité de secteurs logiques de taille identique A correspondant à la taille du plus grand secteur physique possible dans ledit ensemble de mémoires, chaque secteur logique étant susceptible de correspondre à un ou plusieurs secteurs physiques contigus;
- générer, pour chacun des secteurs logiques de ladite mémoire à effacer, un nombre N supérieur à 1 de commandes d'effacement déterminé selon l'équation

$$N = A/S$$

avec S représentant la taille du plus petit secteur physique possible dans ledit ensemble de mémoires ; et
- envoyer les commandes d'effacement à des adresses de la mémoire incrémentées d'un pas correspondant à la taille S du plus petit secteur physique possible dans ledit ensemble de mémoires.

En conséquence, pour pouvoir gérer de façon transparente l'effacement d'une mémoire de type flash sans se soucier a priori de la composition de cette mémoire, l'invention propose de :

- prédéfinir un ensemble de mémoires possibles auquel la mémoire est susceptible d'appartenir ;
- déterminer, dans cet ensemble, la taille A du plus grand secteur et la taille S du plus petit secteur dont on dispose ;

- considérer que la mémoire est partitionnée en une pluralité de secteurs logiques de taille identique A correspondant à la taille du plus grand secteur physique possible dans ledit ensemble de mémoires, chaque secteur logique étant susceptible de correspondre à un ou plusieurs secteurs physiques contigus;

- en déduire le nombre N de commandes d'effacement qu'il faudra appliquer pour l'effacement d'un secteur logique, et ce, quelle que soit la mémoire effectivement utilisée, les commandes d'effacement étant envoyées avec une granularité correspondant à la taille du plus petit secteur physique susceptible d'être présent.

On est ainsi sûr qu'au moins une commande d'effacement sera reçue par chaque secteur physique composant effectivement la mémoire utilisée, et ce, malgré la méconnaissance de la composition exacte de cette mémoire.

La présente invention a également pour objet un compteur électrique comportant au moins une mémoire de type flash, caractérisé en ce que, ladite mémoire étant composée d'un nombre non défini de secteurs physiques de tailles variables et étant choisie dans un ensemble de mémoires possibles de taille mémoire totale T identique, il comporte des moyens de gestion logiciels de l'effacement de ladite mémoire mettant en oeuvre les étapes consistant à :

- Partitionner ladite mémoire en une pluralité de secteurs logiques de taille identique A correspondant à la taille du plus grand secteur physique possible dans ledit ensemble de mémoires, chaque secteur logique étant susceptible de correspondre à un ou plusieurs secteurs physiques contigus;

- générer, pour chacun des secteurs logiques de ladite mémoire à effacer, un nombre N supérieur à 1 de commandes d'effacement déterminé selon l'équation

$$N = A/S$$

avec S représentant la taille du plus petit secteur physique possible dans ledit ensemble de mémoires ; et

- envoyer les commandes d'effacement à des adresses de la mémoire incrémentées d'un pas correspondant à la taille S du plus petit secteur physique possible dans ledit ensemble de mémoires.

La présente invention sera mieux comprise au vu de la description suivante faite en référence aux figures annexées dans lesquelles :

- la figure 1, déjà décrite, illustre un ensemble de trois mémoires possibles ;

- la figure 2 illustre, à titre d'exemple, les commandes d'effacement générées pour l'effacement total de chacune des mémoires de la figure 1, conformément au procédé selon l'invention.

Sur la figure 2, on a repris à titre d'exemple non limitatif, les trois mêmes mémoires 1 à 3 que celles de la figure 1, afin de mieux mettre en évidence les différences du procédé de gestion des effacements entre l'art antérieur et la présente invention.

Selon la présente invention, les trois mémoires 1 à 3 définissent un ensemble de mémoires dans lequel une mémoire particulière sera effectivement implémentée dans un appareil, par exemple dans un compteur électrique. Cet ensemble de trois mémoires, qui ont toutes une taille de mémoire totale T identique, se caractérise par les critères suivants :

- une taille A correspondant au plus grand secteur physique possible dans cet ensemble de mémoires. Cette taille correspond dans l'exemple au quart de la taille totale T des mémoires, et correspond, pour la mémoire 1, aux secteurs physiques $S_1$ à $S_4$, pour la mémoire 2, aux secteurs physiques $S_5$ à $S_6$, et pour la mémoire 3 aux secteurs physiques $S_1$ à $S_3$.

- une taille S correspondant au plus petit secteur physique possible dans cet ensemble de mémoires. Cette taille correspond dans l'exemple à T/32, et correspond, pour la mémoire 2, aux secteurs physiques $S_1$ à $S_2$, et pour la mémoire 3, aux secteurs physiques $S_4$ à $S_5$.
  La mémoire est considérée comme partitionnée en une pluralité de secteurs logiques de taille A regroupant un ou plusieurs secteurs physiques contigus. Dans le cas de la mémoire 1, il y a identité entre les secteurs logiques et les secteurs physiques. Dans le cas de la mémoire 2, trois secteurs logiques correspondent aux secteurs physiques $S_5$, $S_6$ et $S_7$, alors qu'un quatrième secteur logique correspond à la réunion des secteurs physiques $S_1$ à $S_4$. Enfin, dans le cas de la mémoire 2, trois secteurs logiques correspondent aux secteurs physiques $S_1$, $S_2$ et $S3_7$, alors qu'un quatrième secteur logique correspond à la réunion des secteurs physiques $S_4$ à $S_7$.

Le nombre N de commandes d'effacement à générer par secteur logique selon l'invention est donc ici donné par :

$$N = A/S = (T/4)/(T/32) = 8$$

On prévoit donc, dans ce cas, de générer toujours huit commandes d'effacement pour chaque secteur logique de la mémoire utilisée, comme représenté par les flèches en continu à gauche de chaque secteur. De cette façon, la gestion de l'effacement de la mémoire est identique, que la mémoire utilisée soit la mémoire 1, la mémoire 2 ou la mémoire 3. En effet, le nombre total d'effacements nécessaires est toujours égal à 32, et les commandes d'effacement sont envoyées à des adresses de la mémoire incrémentées d'un pas correspondant à la taille S du plus petit secteur physique possible dans ledit ensemble de mémoires.

La mise en oeuvre du procédé de gestion précédent à tout type d'appareil susceptible d'utiliser une mémoire flash, par exemple un compteur électrique, consiste à prévoir, dans le logiciel de gestion de la mémoire compris dans des moyens de gestion, par exemple du type microcontrôleur, une routine pour la génération des commandes d'effacement selon le procédé. Cela permet aux fabricants de compteurs électriques de s'approvisionner en mémoires flash de plusieurs types, tout en standardisant la partie de logiciel relative à l'effacement de la mémoire.

**Revendications**

1.  Procédé de gestion pour l'effacement d'une mémoire de type flash **caractérisé en ce que**, ladite mémoire (1 ; 2 ; 3) étant composée d'un nombre non défini de secteurs physiques ($S_1$ à $S_7$) de tailles variables et étant choisie dans un ensemble de mémoires possibles (1 à 3) de taille mémoire totale T identique, il consiste à :

    - Partitionner ladite mémoire en une pluralité de secteurs logiques de taille identique A correspondant à la taille du plus grand secteur physique possible dans ledit ensemble de mémoires, chaque secteur logique étant susceptible de correspondre à un ou plusieurs secteurs physiques contigus;
    - générer, pour chacun des secteurs logiques de ladite mémoire à effacer, un nombre N supérieur à 1 de commandes d'effacement déterminé selon l'équation

$$N = A/S$$

    avec S représentant la taille du plus petit secteur physique possible dans ledit ensemble de mémoires ; et
    - envoyer les commandes d'effacement à des adresses de la mémoire incrémentées d'un pas correspondant à la taille S du plus petit secteur physique possible dans ledit ensemble de mémoires.

2.  Compteur électrique comportant au moins une mémoire de type flash, **caractérisé en ce que**, ladite mémoire (1 ; 2 ; 3) étant composée d'un nombre non défini de secteurs physiques (1 à 3) de tailles variables et étant choisie dans un ensemble de mémoires possibles de taille mémoire totale T identique, il comporte des moyens de gestion logiciels de l'effacement de ladite mémoire mettant en oeuvre les étapes consistant à :

    - Partitionner ladite mémoire en une pluralité de secteurs logiques de taille identique A correspondant à la taille du plus grand secteur physique possible dans ledit ensemble de mémoires, chaque secteur logique étant susceptible de correspondre à un ou plusieurs secteurs physiques contigus;
    - générer, pour chacun des secteurs logiques de ladite mémoire à effacer, un nombre N supérieur à 1 de commandes d'effacement déterminé selon l'équation

$$N = A/S$$

    avec S représentant la taille du plus petit secteur physique possible dans ledit ensemble de mémoires ; et
    - envoyer les commandes d'effacement à des adresses de la mémoire incrémentées d'un pas correspondant à la taille S du plus petit secteur physique possible dans ledit ensemble de mémoires.

**Claims**

1.  A method of managing erasure in a flash type memory, the method being **characterized in that**, for said memory (1; 2; 3) being made up of a non-defined number of physical sectors ($S_1$ to $S_7$) of varying sizes and being selected from a set of possible memories (1 to 3) of identical total memory size T, it consists in:

    · partitioning said memory into a plurality of logical sectors of identical size A corresponding to the size of the largest possible physical sector in said set of memories, each logical sector being suitable for corresponding to one or more contiguous physical sectors;
    · generating, for each of the logical sectors of said memory for erasure, a number N greater than 1 of erase commands determined by the equation:

$$N = A/S$$

where S represents the size of the smallest possible physical sector in set of memories; and

· sending the erase commands to addresses of the memory incremented by a step size corresponding to the size S of the smallest physical sector possible in said set of memories.

2. An electricity meter including at least one flash type memory, the meter being **characterized in that** said memory (1; 2; 3) is made up of a non-defined number of physical sectors (1 to 3) of varying sizes and being selected from a set of possible memories of identical total memory size T, the meter including software means for erasing said memory and implementing the steps consisting in:

· partitioning said memory into a plurality of logical sectors of identical size A corresponding to the size of the largest physical sector possible in said set of memories, each logical sector corresponding to one or more contiguous physical sectors;

· for each of said logical sectors of said memory for erasing, generating a number N greater than 1 of erase commands determined using the equation:

$$N = A/S$$

where S represents the size of the smallest possible physical sector in said set of memories; and

· sending the erased commands to addresses of the memory incremented by a step size corresponding to the size S of the smallest physical sector possible in said set of memories.

**Patentansprüche**

1. Verfahren zur Steuerung des Löschens eines Flash-Speichers, **dadurch gekennzeichnet, dass** der Speicher (1; 2; 3) aus einer nicht definierten Anzahl physischer Bereiche ($S_1$ bis $S_7$) mit variablen Größen besteht und aus einer Gesamtheit möglicher Speicher (1 bis 3) mit identischer Gesamtspeichergröße T ausgewählt wird und das Verfahren besteht aus:

- Partitionieren des Speichers in eine Mehrzahl logischer Bereiche mit identischer Größe A, die der Größe des größten möglichen physischen Bereichs in der Gesamtheit der Speicher entspricht, wobei jeder logische Bereich geeignet ist, einem oder mehreren nebeneinander liegenden physischen Bereichen zu entsprechen;

- für jeden der zu löschenden logischen Bereiche des Speichers Erzeugen eine Anzahl N größer als 1 Löschbefehle, wobei die Anzahl gemäß der Gleichung

$$N = A/S$$

bestimmt wird, wobei S die Größe des kleinsten möglichen physischen Bereichs in der Gesamtheit der Speicher darstellt, und

- Senden der Löschbefehle zu Adressen des Speichers, die um einen Schritt inkrementiert sind, der der Größe S des kleinsten möglichen physischen Bereichs in der Gesamtheit der Speicher entspricht.

2. Stromzähler, der mindestens einen Flash-Speicher aufweist, **dadurch gekennzeichnet, dass** er, wobei der Speicher (1; 2; 3) aus einer nicht definierten Anzahl physischer Bereiche (1 bis 3) mit variablen Größen besteht und aus einer Gesamtheit möglicher Speicher mit identischer Gesamtspeichergröße T ausgewählt wird, Softwareverwaltungsmittel zum Löschen des Speichers aufweist, die die folgenden Schritte umsetzen:

- Partitionieren des Speichers in eine Mehrzahl logischer Bereiche mit identischer Größe A, die der Größe des größten möglichen physischen Bereichs in der Gesamtheit der Speicher entspricht, wobei jeder logische Bereich geeignet ist einem oder mehreren nebeneinander liegenden physischen Bereichen zu entsprechen;

- für jeden der zu löschenden logischen Bereiche des Speichers Erzeugen eine Anzahl N größer als 1 Löschbefehle, wobei die Anzahl gemäß der Gleichung

$$N = A/S$$

bestimmt wird, wobei S die Größe des kleinsten möglichen physischen Bereichs in der Gesamtheit der Speicher darstellt, und

- Senden der Löschbefehle zu Adressen des Speichers, die um einen Schritt inkrementiert sind, der der Größe S des kleinsten möglichen physischen Bereichs in der Gesamtheit der Speicher entspricht.

**FIG. 1**

**FIG. 2**